# EUROPEAN PATENT APPLICATION

(11) **EP 1 548 805 A1**
(43) Date of publication of application: **29.06.2005**
(21) Application number: 03766745.8
(22) Date of filing: 05.08.2003
(51) Int. Cl.: H01L 21/027, G03F 1/16, G03F 7/20

(54) **COMPLEMENTARY DIVISION MASK HAVING ALIGNMENT MARK, METHOD FOR FORMING ALIGNMENT MARK OF THE COMPLEMENTARY DIVISION MASK, SEMICONDUCTOR DEVICE MANUFACTURED BY USING THE COMPLEMENTARY DIVISION MASK, AND ITS MANUFACTURING METHOD**

(30) Priority: 05.08.2002 JP 2002227670
(71) Applicant: Sony Corporation, Tokyo 141-0001 (JP)
(72) Inventor: NOHDO, Shinichiro, c/o SONY CORPORATION, Shinagawa-ku, Tokyo 141-0001 (JP); AMAI, Keiko, c/o SONY CORPORATION, Shinagawa-ku, Tokyo 141-0001 (JP)
(74) Representative: Müller, Frithjof E., Dipl.-Ing.
(86) International application number: PCT/JP2003/009926
(87) International publication number: WO 2004/013904

(57) **Abstract**

In fabrication of a semiconductor device having plural patterns on a plurality of layers by using complementary divided masks each having alignment marks distributed therein, because of the presence of a plurality of complementary divided mask layers, misalignment between respective layers tends to occur. To solve this problem, divided alignment marks (M1a, M2a, M3a, M4a) are formed in respective complementary divided regions corresponding to respective blocks (B1, B2, B3, B4) of complementary divided masks obtained by dividing a stencil mask. By distributing alignment marks to respective complementary divided masks, a positional deviation between respective masks is averaged, thereby enabling to fabricate a semiconductor device in which a large positional deviation between patterns of adjoining layers is eliminated.

## Description

### TECHNICAL FIELD

The present invention relates to a complementary divided mask for enabling a high precision patterning when carrying out alignment of patterns of a plurality layers using a stencil mask subjected to complementary dividing by substantially improving the alignment therebetween, a method of forming alignment marks for the complementary divided mask, a semiconductor device that is manufactured using the complementary divided mask, and a method of manufacturing the same.

### BACKGROUND ART

As to a stencil mask to be used in LEEPL or an EB stepper, a complementary divided mask is noted to be necessary in order to prevent a "doughnut" pattern from falling off the mask or a pattern from collapsing due to a tensile force of a cleaning solution during cleaning. In this instance, in the case where a plurality of complementary divided masks are to be formed using a kind of alignment marks, there occur the following problems.

That is, because these alignment marks are mostly in a simple structure of rectangles deployed in an array, there occurs such a problem that if they are subjected to an automatic complementary dividing software as they are without adding a specific designation thereto, a desirable complementary dividing cannot be achieved, and it may result that these alignment marks are concentrated undesirably in one block.

This problem resulting from the concentration of the alignment marks will be described by way of example in terms of a precision deterioration in the case where a stencil mask is divided into four blocks of complementary divided mask A to D.

Let assume a complementary divided block A have deviated by 30 nm in a process of its mask fabrication, and the other complementary divided blocks B to D have deviated 0 nm. For these four mask blocks, if alignment marks are formed only in the complementary divided block A, in a subsequent process of alignment of layers, the alignment therefore is adjusted to the complementary divided block A, thereby resulting for the complementary divided mask blocks B to D to be deviated by -30 nm, respectively.

As described above, if the alignment marks are formed only in one of the complementary divided blocks, because a deviation in any one of the complementary divided blocks selected will be added to the other complementary divided blocks, there may be a possibility that a substantial deviation of the alignment marks in the subsequent process occurs depending on any specific complementary block having been selected.

According to a conventional method of forming alignment marks, it is possible to hold an optimum relationship in terms of relative positions between a first layer's pattern and a second layer's pattern (for example, as disclosed in Japanese Patent Application Publication No. HEI7-312333), however, if this method is applied to a complementary divided mask, the aforementioned problems will occur.

The present invention is contemplated to solve the aforementioned problems, and the object thereof is to provide a novel complementary divided mask which can be formed while ensuring for a first layer's pattern and a second layer's pattern to be held in an optimum relative positional relationship, i.e. with a least deviation in alignment when carrying out patterning of a semiconductor device using the complementary divided mask, a novel method of forming alignment marks for the complementary divided mask, a semiconductor device to be manufactured using the complementary divided mask, and a method of manufacturing the same.

### DISCLOSURE OF THE INVENTION

The present invention is directed to a complementary divided mask obtained by dividing a stencil mask into a plurality of mask blocks, which is characterized in that alignment marks are formed in a respective complementary divided region corresponding to each of the plurality of complementary divided mask blocks, to a method of forming the alignment marks in the complementary divided masks, a semiconductor device to be manufactured using the complementary divided masks, and a method of manufacturing the semiconductor device.

The present invention will be described in detail in the following.

The present invention is concerned with a complementary divided mask and the like which enables to form respective patterns of respective layers in a semiconductor device without substantially deteriorating an alignment precision therebetween even in the case where the complementary divided mask is used in order to solve the doughnut pattern falling problem and the like.

As described above, if the alignment marks are distributed among the complementary divided mask blocks without specifying them particularly, there occurs that the distribution of the alignment marks tend to be concentrated in one single complementary divided mask block, in this instance, alignment of the other complementary divided mask blocks will depend on the single complementary divided mask block in which the alignment marks have been concentrated, thereby causing for the complementary divided mask blocks having no or less alignment marks to have a large deviation in alignment thereof, this tendency becoming more remarkable when forming multi layered patterns.

If the alignment marks are distributed appropriately to respective complementary divided mask blocks divided according to the present invention, because a respective deviation in alignment can be corrected for a respective complementary divided mask, a total deviation in alignment can be minimized.

In other words, by appropriately distributing alignment marks to respective mask blocks by a method of forming alignment marks according to the present invention, an averaging effect is produced advantageously, thereby enabling to secure an adequate margin for retaining a registration precision over the whole of a chip.

Preferably, respective marks constituting the alignment marks are disposed in an array having a plurality of columns which are formed spaced apart therebetween at equidistance, and a complementary divided mask is formed having a plurality of rows thereof equally distributed therebetween. As an exposure beam to irradiate the mask, a charged particle beam, an extreme ultraviolet ray, X-ray, a radiation beam or a visible light may be used.

Although the alignment marks usable in the embodiment of the present invention are not limited to any specific type, preferably, it is a simple structure having a plurality of rectangular unit marks such as a square or the like arranged vertically and horizontally in an array, or any conventional unit marks such as bar-like unit marks which are disposed evenly in a horizontal direction may be used as well. If these unit marks are arranged evenly, because these alignment marks can be formed using an averaging type writing method, an alignment precision in a subsequent layer can be improved. Further, a complementary divided region on which the alignment marks are to be formed is a region where a pattern thereof and a pattern of a subsequent layer corresponding thereto do not overlap, and preferably the region thereof corresponds to a registration margin required.

In the complementary divided masks, a positional precision required in a respective mask may differ from one another. In this instance, it can be dealt with by adjusting the number of or the size of unit marks to be distributed to respective complementary divided masks. For example, in the case of dealing with this situation by adjusting the number of unit marks, if these unit marks are arranged in an array having a plurality of columns and a plurality of rows, it is possible to distribute more columns and/or more rows to a complementary divided mask which requires a higher positional precision, and less columns and/or less rows to a complementary mask which requires a less positional precision, thereby allowing to dispose the alignment marks efficiently by utilizing a required number of unit marks.

By sequentially irradiating a plurality of complementary divided masks having the alignment marks arranged as described above with a charged particle beam, the surface of a semiconductor device is irradiated with the charged particle beam having passed through the complementary divided masks to form a pattern structure thereon corresponding to a desired pattern provided on respective complementary divided masks, thereby enabling to form a desired wiring pattern. Further, a pattern of a subsequent layer is formed with a minimum positional deviation utilizing these alignment marks. By repeating this process appropriately, a desirable semiconductor device having a minimum deviation between respective patterns can be fabricated.

### BRIEF DESCRIPTION OF THE DRAWINGS

FIG. 1 (A) is a schematic diagram showing complementary blocks divided according to a first embodiment of the present invention while FIG. 1 (B) is a schematic diagram showing an arrangement of alignment marks distributed corresponding to respective complementary blocks of FIG. 1 (A).
FIG. 2A is a schematic diagram showing complementary blocks divided according to a second embodiment of the present invention while FIG. 2B is a schematic diagram showing an arrangement of alignment marks distributed corresponding to respective complementary blocks of FIG. 2A.
FIG. 3 is a plan view showing an example of a mask according to the present invention.
FIG. 4 is a cross-sectional view showing an example of a mask according to the present invention.
FIG. 5 is a perspective view showing an example of a mask according to the present invention.
FIG. 6 is a schematic diagram showing an example of an exposure apparatus for use in LEEPL according to the present invention.
FIG. 7 is a schematic diagram showing an example of a projection optical system in an electron beam photolithography apparatus which the mask according to the present invention is applicable to.
FIG. 8 is a flowchart of a method for manufacturing a semiconductor device according to the present invention.

### BEST MODE FOR CARRYING OUT THE INVENTION

Fabrication of alignment marks according to a preferred embodiment of the present invention will be described in the following, however, it should be noted that the present invention is not limited thereto.

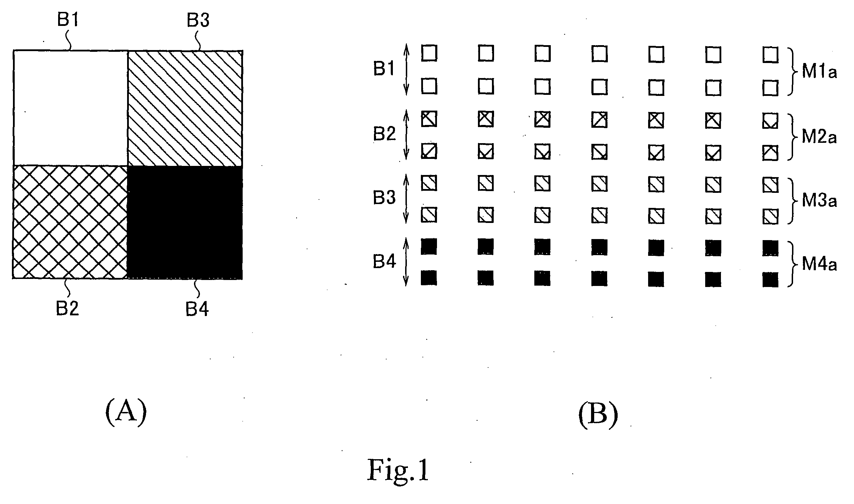

A first embodiment of the present invention will be described by referring to FIGS. 1 (A) and 1 (B).

A stencil mask is divided into four blocks of complementary divided masks as shown in FIG. 1 (A), and an exemplary arrangement of respective alignment marks corresponding thereto is shown in FIG. 1 (B), in which an optical lithography LSA alignment is used. It should be noted, however, that the present invention is not limited to the LSA alignment, but also an optical lithography FIA, LIA alignment, X-ray SLA alignment in LEEPL can be used.

Corresponding to respective complementary blocks (complementary divided masks) 1B, 2B, 3B and 4B shown in FIG. 1 (A), there exist respective divided alignment marks M1a, M2a, M3a and M4a as shown in FIG. 1 (B). As clearly known from FIG. 1 (B), respective sets of the divided alignment marks M1a to M4a are formed corresponding to the respective blocks by arranging two rows each having seven pieces of square marks each separated at equidistance, and also respective rows for the sets being arranged equally in the vertical direction.

The alignment marks M1a to M4a are formed simultaneously with the fabrication of the complementary divided masks B1 to B4, for example, of a first layer. Then, when forming a pattern according to a second layer, the preceding alignment marks M1a to M4a of the first layer are detected, and on the_ basis of these alignment marks M1a to M4a detected, a pattering for the second layer is carried out using the second complementary divided mask divided into four complementary blocks, and at the same time, alignment marks are formed on this second layer, this operation being repeated as many as required.

At the time of forming the pattern according to the second layer where the preceding alignment marks M1a to M4a are utilized, it becomes possible to detect an average deviation in alignment, thereby enabling substantially to reduce a quantity of deviation in comparison with a case where alignment marks are formed only in one of the complementary divided masks.

Let's assume respective deviations (registration errors) in alignment of respective complementary blocks, for example, be -10 nm in a complementary block B1, +10 nm in a complementary block B2, +10 nm in a complementary block B3 and +50 nm in a complementary block B4.

If these deviations in alignment (registration errors) are to be obtained by a conventional method on the basis of the complementary block B4 as a reference, there occur registrations errors in alignment of -60 nm in the complementary block B1, +40 nm in the complementary block B2, -40 nm in the complementary block B3 and ±0 nm in the complementary block B4. Consequently, a total average deviation in alignment of -50nm will occur.

On the other hand, if alignment is carried out using the alignment marks shown in FIG. 1 (B), their deviations in alignment are averaged, and consequently, a specific value of detection will become +15 nm (= (-10 + 10 + 10 + 50)/4).

If a pattern is drawn using this result of mark detection, registration errors of the complementary blocks B1, B2, B3 and B4 will become -25 nm, -5 nm, -5 nm and +35 nm, respectively, thereby in comparison with the aforementioned conventional method, a maximum registration error (deviation in alignment) is reduced from the +60 nm to +35 nm.

From the above discussion, it is clearly known that the method of the present invention for distributing alignment marks equally to respective complementary divided regions is more effective to reduce the deviations in alignment, i.e., registration errors than the conventional method of obtaining a deviation in alignment by allowing a single alignment mark to be concentrated in one complementary divided block.

In the next, a method according to a second embodiment of the present invention will be described whereby, when dividing a stencil mask into plural complementary blocks, a positional precision required in respective complementary blocks is set up in advance, and a pattern thereof is subjected to complementary dividing in accordance with this rule of set up.

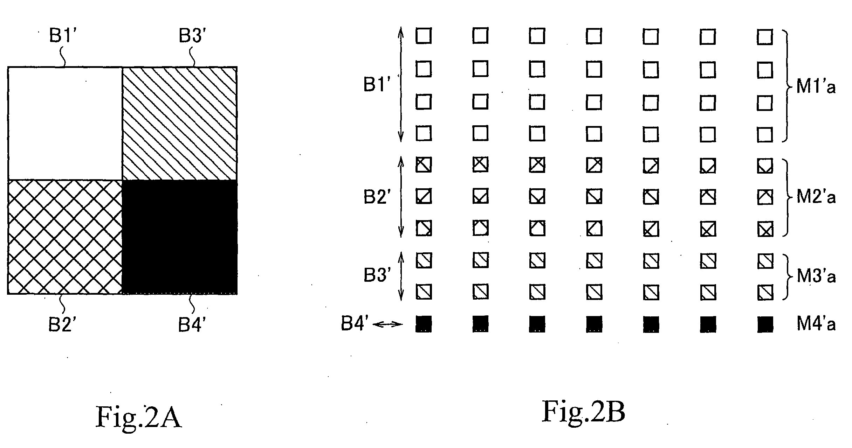

In the description of this embodiment of the invention, it is assumed for a respective positional precision required in each of the four portioned blocks B1' to B4' of complementary masks obtained by dividing a stencil mask as shown in FIG. 2A such that 30 nm of a patterning precision in a complementary block B1', 60 nm of a patterning precision in a complementary block B2', 90 nm of a patterning precision in a complementary block B3', and 120 nm of a patterning precision in a complementary block B4'.

According to the second embodiment of the present invention, in response to respective positional precision requirements in these complementary blocks B1' to B4', as shown in FIG. 2B, as to the complementary block B1' for which the maximum positional precision of 30 nm patterning precision is required, a divided alignment mark set M1'a is distributed, which has four rows each including seven pieces of square marks aligned horizontally at equidistance, and as to the complementary block B2' for which the second positional precision of 60 nm patterning precision is required, a divided alignment mark set M2'a is distributed which has three rows each including seven pieces of square marks aligned horizontally at equidistance. Further, as to a complementary block B3' which requires a third positional precision of 90 nm of patterning precision, a divided alignment mark set of M3'a is distributed which has two rows each including seven pieces of square marks aligned horizontally at equidistance, then as to a complementary block B4'which requires a minimum positional precision of 120 nm of patterning precision, a divided alignment mark set of M4'a is distributed which has a single row of seven pieces of square marks aligned horizontal at equidistance.

Thereby, a total of ten rows having the alignment marks are distributed in the numbers of four rows, three rows, two rows and one row, respectively, in the order of the highest to the lowest precision requirements thereby enabling for the alignment marks to be utilized most efficiently as required in respective complementary blocks.

Thereby, it is enabled to weight the alignment marks depending on a respective alignment precision requirement in each of the complementary blocks, thereby enabling to secure a precision of a registration margin corresponding to a specific registration margin required for a subsequent process of patterning with respect to a plurality of existing patterns, thereby adapting appropriately even to such a case where a respective registration margin required differs one another.

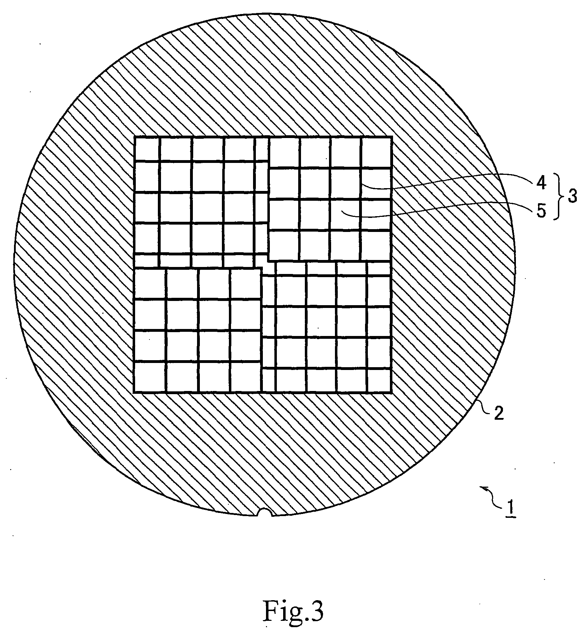

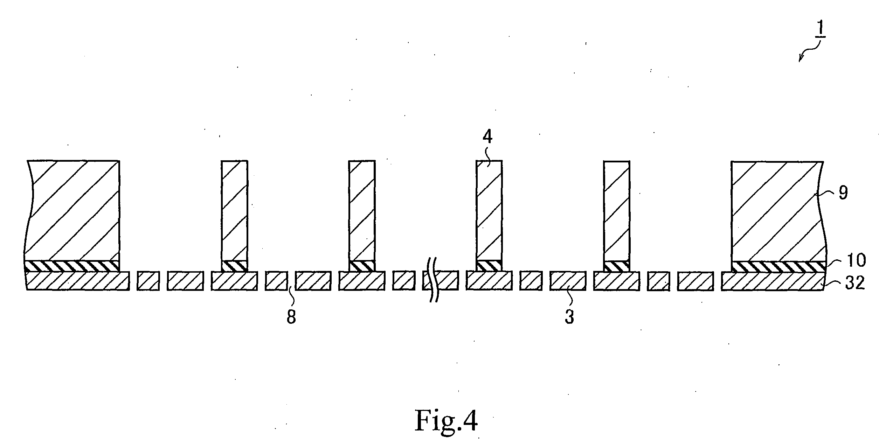

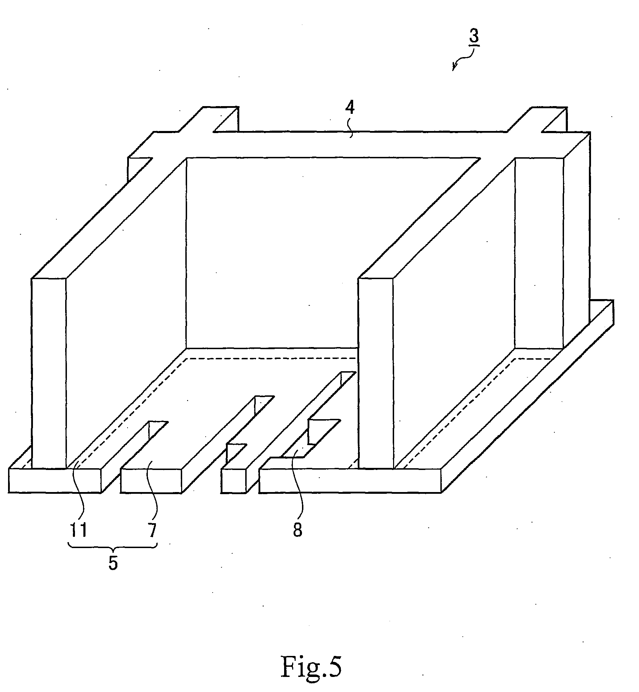

The stencil mask according the embodiment of the present invention is suitable for use in the LEEPL. FIG. 3 is a plan view showing a schematic diagram of a stencil mask 1 according to the embodiment of the present invention. Further, FIG. 4 is a cross-sectional view of the schematic diagram of the stencil mask 1 according to the embodiment of the invention. FIG. 5 is a perspective view showing the schematic diagram of the stencil mask 1 thereof.

As shown in FIG. 3, the stencil mask 1 is fabricated using a silicon wafer 2. A center portion of the silicon wafer 2 is removed in a square-like form, and in which a membrane 3 is formed. A thick film portion of the silicon wafer 2 surrounding the membrane 3 is used as a support frame 9 for supporting the membrane 3 which is a thin film. In the membrane 3, a beam 4 is formed in a grid-like arrangement. The beam 4 is remaining portions in the silicon wafer 2 after a plurality of openings are formed therein. Every end of the beam 4 is in connection with the support frame 9 or with another beam 4, and is never disconnected.

In the following description, a square portion surrounded by the beam 4 in the membrane 3 is referred to as a membrane divided region 5. A skirt portion 11 of a small width and parallel thereto is formed on both sides of the beam in the membrane 3. A portion excluding the skirt portion 11 in the membrane divided region 5 is defined as a pattern region 7. Further, a portion including the beam 4 and the skirt 11 is defined as a beam zone. Numeral 32 in FIG. 4 depicts a membrane forming layer, 8 depicts a hole, and 10 depicts a silicon oxide film.

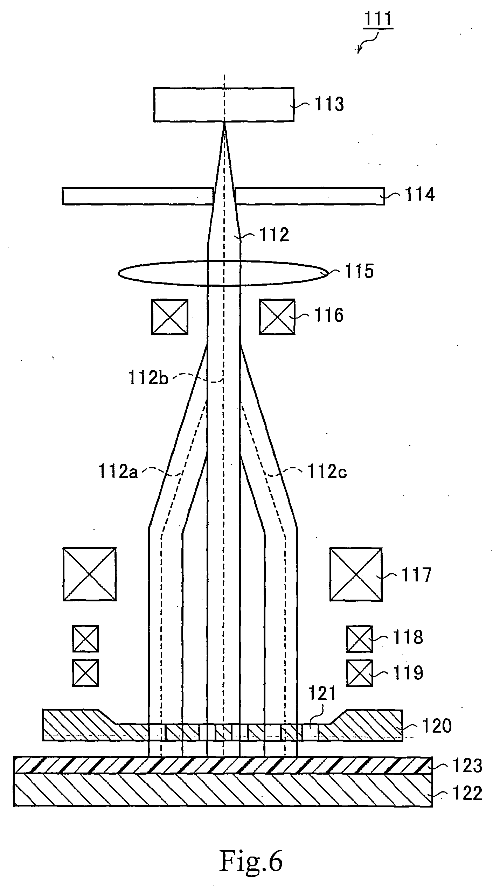

FIG. 6 is a schematic diagram of an electron beam photolithography apparatus for use in the LEEPL, and shows an optical system thereof. The stencil mask according to the embodiment of the present invention can be used preferably in the electron beam photolithography apparatus as shown in FIG. 6.

The photolithography apparatus 111 shown in FIG. 6 is provided, in addition to an electron gun 113 for generating electron beam 112, with an aperture 114, a condenser lens 115, a pair of main deflectors 116, 117 and pairs of fine tuning deflectors 118, 119.

The aperture 114 functions to limit the electron beam 112. A cross-section of the electron beam 112 condensed by the condenser lens 115 is normally circular, however, it is not limited thereto, so it may have any cross-sectional shape. The main deflectors 116, 117 and the fine tuning deflectors 118, 119 are made of deflecting coils, and in particular, the main deflectors 116, 117 function to deflect the electron beam 112 to allow for the electron beam 112 to impinge on the surface of the stencil mask 120 basically at an angle of incidence perpendicular thereto.

The fine tuning deflectors 118, 119 function to deflect the electron beam 112 so that the electron beam 112 falls on the surface of the stencil mask 120 perpendicular thereto or at an incidence angle slightly tilted relative to the perpendicular direction. Although an angle of incidence of the electron beam 112 is optimized in dependence on a particular position of a pattern or the like on the stencil mask 120, the angle of incidence of the electron beam 112 is approximately 10 mrad at largest even if tilted, and thus it falls on the stencil mask 120 virtually perpendicular thereto.

Electron beams 112a to 112c shown in FIG. 6 indicate how the electron beam 112 scanning over the stencil mask falls on respective positions on the stencil mask, i.e., at an angle of incidence which is substantially perpendicular thereto, however, it is not meant that they impinge on the stencil mask 120 simultaneously. The scanning by the electron beam 112 may be a raster scanning or a vector scanning.

In FIG. 6, a resist 123 on a wafer 122 is exposed by electron beams having transmitted hole sections 121 in the stencil mask 120. An equi-magnification mask is used for LEEPL, and the stencil mask 120 and the wafer 122 are placed in proximity.

When carrying out the electron beam exposure using the above-mentioned electron beam photolithography apparatus 111, a stencil mask according to the embodiment of the present invention is used as the stencil mask 120. In the stencil mask according to the embodiment of the present invention, because its membrane is supported and reinforced by the support layer, a deflection of the membrane is prevented thereby substantially reducing a positional deviation in a transcription pattern during the electron beam exposure.

Further, because the opening section in the support layer is formed in self-alignment with respect to the hole section of the membrane, it does not occur that any electron beam which is to pass through the hole section is interrupted by the support layer. In the case where the opening section in the support layer is not formed in self-alignment with respect to the hole section of the membrane, a patterning of a resist for forming the opening section in the support layer is carried out separately from a patterning of a resist for forming the hole section of the membrane, then the opening in the support layer is formed by etching using the resist thereon as a mask.

Although the opening section in the support layer can be formed by the method described above as well, it should be noted in this case, however, that if a precision of alignment between the patterning of the resist on the support layer and the patterning of the resist on the membrane is not adequate, there may occur such a problem that the electron beam which is to pass through the hole section is blocked by a portion of the support layer. Therefore, in particular, in the case of forming a fine pattern with a minimum registration margin, it is more preferable to form the opening section in the support layer in self-alignment with respect to the hole section of the membrane as described above.

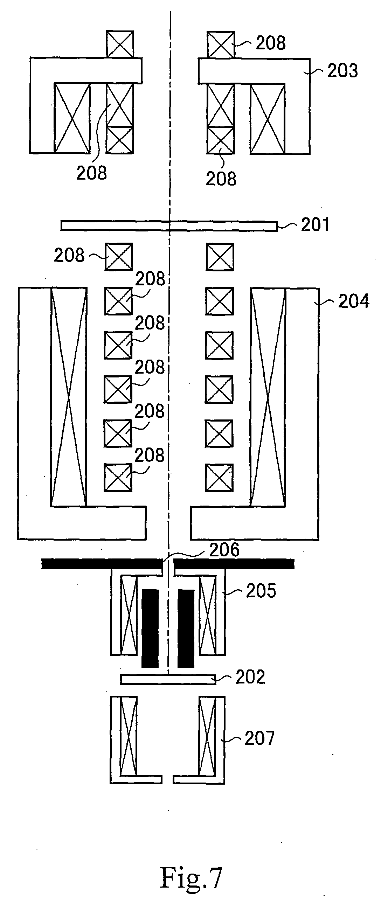

FIG. 7 is a schematic diagram showing an example of a projection optical system of another electron beam photolithography apparatus to which the mask according to the embodiment of the present invention can be applied. According to this projection optical system shown in FIG. 7, a pattern on a mask 201 is transcribed at a predetermined reduced magnification onto a specimen 202 of a wafer or the like using an electron beam. Activation of the electron beam is controlled by a condenser lens 203, a first projection lens 204, a second projection lens 205, a cross-over aperture 206, a bottom specimen lens 207 and a plurality of deflectors 208.

In the projection optical system shown in FIG. 7, deflecting magnetic fields are generated from a plurality of deflectors 208 so that an electron beam having passed through the mask 201 then through the cross-over aperture 206 falls on the specimen 203 perpendicular thereto. The mask according to the embodiment of the present invention is also applicable to any other charged particle beam lithography apparatus or the like that employs the aforementioned projection optical system or the aforementioned stencil mask.

It is to be noted here that the mask, the method of manufacturing the same, and the method of manufacturing the semiconductor device using the same according to the embodiment of the present invention are not limited to the above exemplary description set forth heretofore. For example, the mask and the method of manufacturing the same according to the embodiment of the present invention can be also applied to a charged particle transcription type machine other than the LEEPL. More particularly, the present invention can be applied to a stencil mask and a method of manufacturing the same for use in a PREVAIL, an electron beam direct drawing machine of a variable forming type or in an ion beam lithography apparatus. It is also possible to apply the present invention to a mask and a method of manufacturing the same for use in an X-ray lithography apparatus. Further, it should be understood that various changes, modifications and combinations are possible without departing from the scope of the present invention.

According to the method of manufacturing the mask according to the embodiment of the present invention, it becomes possible to form a high precision patterning on the membrane.

According to the method of manufacturing a semiconductor device according to the embodiment of the present invention, it becomes possible to transcribe a fine pattern at a high precision in a charged particle transcription type lithography apparatus.

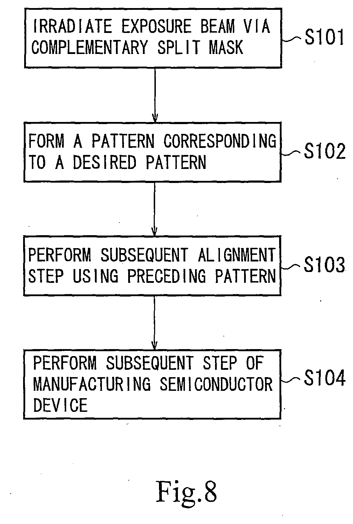

FIG. 8 shows a flowchart describing a method of manufacturing a semiconductor device according to the embodiment of the present invention. After a step (S101) of irradiating an electron beam through the complementary divided mask according to the embodiment of the present invention, a step (S102) is carried out for forming a pattern on a wafer corresponding to a desired pattern of the mask. Then, a step (S103) is carried out in which an alignment operation in a subsequent process is carried out using the preceding pattern, then, followed by a step (S104) of manufacturing the semiconductor device. By use of the method of manufacturing the semiconductor device and the complementary divided mask according to the embodiment of the present invention, it is enabled to minimize the positional deviation, i.e. the registration error between the patterns of adjoining layers in a semiconductor device, thereby enabling to obtain a high performance semiconductor device.

Any appropriate exposure beams in addition to the charged particle beam can be utilized including such as a EUV (extreme ultraviolet), an X-ray, a radiation ray, or even a visible ray.

### INDUSTRIAL APPLICABILITY

As clearly understood from the description heretofore, when the alignment marks are distributed to respective complementary masks according to the embodiment of the present invention, the averaging effect is produced advantageously between respective mask blocks to ensure for a registration precision to be secured over the entire portion of a chip, thereby minimizing the positional deviation between the patterns of the adjoining layers in the semiconductor device which uses the complementary divided masks, and thereby enabling to obtain a high performance semiconductor device.

## Claims

1. A complementary divided mask obtained by dividing a stencil mask into a plurality of complementary divided mask blocks, said complementary divided mask being **characterized in that**:
alignment marks are formed in a respective complementary divided region corresponding to each of said plurality of complementary divided mask blocks.

2. The complementary divided mask as described in claim 1,
**characterized in that**:
said plurality of complementary divided mask blocks comprise four complementary divided regions.

3. The complementary divided mask as described in claim 1,
**characterized in that**:
said alignment marks are equally distributed to each of said complementary divided regions.

4. The complementary divided mask as described in claim 3,
**characterized in that**:
respective marks constituting said alignment marks are arranged as a plurality of rows in which said respective marks are spaced apart therebetween at equidistance, and distance of said respective rows are equally distributed therebetween.

5. The complementary divided mask as described in claim 1,
**characterized in that**:
said alignment marks are unequally distributed to each of said complementary divided regions depending on respective positional precision requirements in each of said complementary divided regions.

6. The complementary divided mask as described in claim 5,
**characterized in that**:
respective marks constituting said alignment marks are arranged as a plurality of rows, and a number of said rows having said alignment marks in each of said complementary divided regions differs one another.

7. The complementary divided mask as described in claim 1,
**characterized in that**:
said alignment marks are formed in said complementary divided regions with a registration margin corresponding to that required for a subsequent process of patterning with respect to a plurality of existing patterns.

8. The complementary divided mask as described in claim 1,
**characterized in that**:
respective marks constituting said alignment marks are arranged in an array.

9. A method for forming alignment marks in a complementary divided mask, **characterized by** comprising:
dividing a stencil mask into a plurality of complementary divided mask blocks,
distributing said alignment marks in a respective complementary divided regions corresponding to each of said plurality of complementary divided mask blocks, and
carrying out an alignment operation in a subsequent process using said alignment marks.

10. The method for forming alignment marks as described in claim 9,
**characterized in that**:
said plurality of complementary divided mask blocks comprise four complementary divided regions.

11. The method for forming alignment marks as described in claim 9,
**characterized in that**:
said alignment marks are equally distributed to each of said complementary divided mask blocks.

12. The method for forming alignment marks as described in claim 11,
**characterized in that**:
respective marks constituting said alignment marks are arranged as a plurality of rows in which said respective marks are spaced apart therebetween at equidistance, and distance of said respective rows are equally distributed therebetween.

13. The method for forming alignment marks as described in claim 9,
**characterized in that**:
said alignment marks are unequally distributed to each of said complementary divided mask blocks depending on respective positional precision requirements in each of said complementary divided mask blocks.

14. The method for forming alignment marks as described in claim 13,
**characterized in that**:
respective marks constituting said alignment marks are arranged as a plurality of rows, and a number of said rows having said alignment marks in each of said complementary divided mask blocks differs one another.

15. The method for forming alignment marks as described in claim 9,
**characterized in that**:
said alignment marks are formed in said complementary divided regions with a registration margin corresponding to that required for a subsequent process of patterning with respect to a plurality of existing patterns.

16. The method for forming alignment marks as described in claim 9,
**characterized in that**:
respective marks constituting said alignment marks are arranged in an array.

17. A semiconductor device **characterized by**:
irradiating a complementary divided mask with an exposure beam, said mask obtained by dividing a stencil mask into a plurality of complementary divided mask blocks, and equally distributing alignment marks in a respective complementary divided regions corresponding to each of said plurality of complementary divided mask blocks, and prepared for carrying out an alignment operation in a subsequent process using said alignment marks;
irradiating the surface of said semiconductor device with said exposure beam having passed through said complementary divided masks; and
forming thereon a pattern structure corresponding to a desired pattern provided on said stencil masks.

18. The semiconductor device as described in claim 17, **characterized in that**:
said exposure beam is one selected from the group consisting of a charged particle beam, an extreme ultraviolet ray, X-ray, a radiation beam and a visible light.

19. A method for manufacturing a semiconductor device, **characterized by** comprising:
dividing a stencil mask into a plurality of complementary divided masks,
equally distributing said alignment marks in a respective complementary divided regions corresponding to each of said plurality of complementary divided masks,
irradiating said complementary divided masks with a charged particle beam,
irradiating the surface of said semiconductor device with said charged particle beam having passed through said complementary divided masks,
forming thereon a pattern structure corresponding to a desired pattern provided on said stencil mask, and
carrying out an alignment operation in a subsequent process using said alignment marks.

20. The method for manufacturing a semiconductor device as described in claim 19, **characterized in that**:
said exposure beam is one selected from the group consisting of a charged particle beam, an extreme ultraviolet ray, X-ray, a radiation beam and a visible light.
